# EUROPÄISCHE PATENTSCHRIFT

(11) **EP 1 499 171 B1**
(45) Veröffentlichungstag und Bekanntmachung des Hinweises auf die Patenterteilung: **07.06.2006**
(21) Anmeldenummer: 03016291.1
(22) Anmeldetag: 18.07.2003
(51) Int. Cl.: H05K 7/14

(54) **Ein -und Ausziehvorrichtung einer Steckbaugruppe in bzw. aus einem Baugruppenträger**
Device for inserting, extracting a plug-in unit in a bay
Dispositif d'insertion, d'extraction d'une unité enfichable dans une baie

(43) Veröffentlichungstag der Anmeldung: 19.01.2005
(73) Patentinhaber: Schroff GmbH, D-75334 Straubenhardt (DE)
(72) Erfinder: Joist, Michael, 76571 Gaggenau (DE)
(74) Vertreter: Durm, Frank

(56) Entgegenhaltungen:
- EP-A- 0 832 547
- DE-A- 4 105 948
- US-A- 5 140 501

## Beschreibung

Die Erfindung betrifft eine Steckbaugruppe zum Einstecken und Ausziehen in bzw. aus einem Baugruppenträger, der wenigstens eine vordere Anschlagkante aufweist. Die Steckbaugruppe umfasst einen im Frontbereich der Steckbaugruppe schwenkbar gelagerten Hebelziehgriff mit einem Griffarm und einem Hebelarm.

Steckbaugruppen weisen an ihrem hinteren Ende einen vielpoligen Steckverbinder auf, der in eine korrespondierende Steckerleiste auf der Rückverdrahtungsplatine des Baugruppenträgers eingesteckt wird. Zum Herstellen wie auch zum Lösen der Steckverbindung sind große Kräfte aufzubringen. Hierzu umfassen die Steckbaugruppen in der Regel in ihrem Frontbereich einen unteren und einen oberen Hebelziehgriff, mit denen die Steckbaugruppen in den Baugruppenträger eingehebelt bzw. aus dem Baugruppenträger ausgehebelt werden können. Zu Beginn des Einhebelns müssen die Hebelziehgriffe vollständig ausgeschwenkt sein. Beim oberen Hebelziehgriff stellt sich das Problem, dass der lange Hebelarm, der als Griffarm ausgebildet ist, aufgrund der Schwerkraft nach unten fällt, wodurch der Hebelziehgriff von selbst unbeabsichtigt nach unten verschwenkt. Damit behindert der Hebelziehgriff das Einschieben der Steckbaugruppe; ein vollständiges Einstecken der Steckbaugruppe in den Baugruppenträger ist in dieser Position des Hebelziehgriffs nicht möglich. Der Bediener der Steckbaugruppe muss hier manuell eingreifen, um den Hebelziehgriff in die entsprechende Position zu bringen und kann erst dann mit dem Einhebeln beginnen.

Im Stand der Technik sind einige Hebelziehgriffe bekannt, die in einer Endposition verrastet oder verriegelt werden können.

Aus der DE 41 05 948 C2 ist eine Baugruppeneinheit mit einem Hebel zum Einsetzen der Baugruppe in einer Aufnahme bekannt. An einem langen Hebelarm des Hebels ist ein Griffhebel schwenkbar gelagert. Ein federndes Rastmittel verrastet den Hebel bei vollständig eingesteckter Baugruppe. Die Verrastung wird durch Verschwenken des Griffhebels gelöst. Das Rastmittel ist dazu geeignet, den Hebel in seiner eingeschwenkten Position zu verriegeln. Ein Fixieren des Hebels in seiner vollständig ausgeschwenkten Endposition ist dagegen nicht vorgesehen und kann von dem vorgeschlagenen Rastmittel auch nicht geleistet werden.

Aus der EP 0 832 547 B1 ist ein Frontsystem einer Flachbaugruppe mit einem Eckstück bekannt, an dem ein Hebelziehgriff angebracht ist. Dieser weist Mittel zur Fixierung des Hebelziehgriffs auf. Der Hebelziehgriff kann jedoch nur bei vollständig in den Baugruppenträger eingeschobener Flachbaugruppe in seiner entsprechenden Endposition fixiert werden. Es werden keine Mittel gezeigt, den Hebelziehgriff auch im ausgeschwenkten Zustand zu fixieren.

Aus der US 5 140 501 ist ein Hebelziehgriff bekannt, der in einer Endposition verriegelt werden kann.

Im Stand der Technik sind darüber hinaus Hebelziehgriffe bekannt, die mittels einer integrierten Feder in der ausgeschwenkten Position gehalten werden. In der Praxis haben sich solche Federn jedoch als ungeeignet erwiesen, da sie mit der Zeit überdehnt und weich werden. Ein zuverlässiges Halten des Hebelziehgriffs ist dann nicht mehr gewährleistet. Beim Einschieben der Steckbaugruppe in den Baugruppenträger muss der Hebelziehgriff manuell betätigt werden, um die Federkraft zu überwinden. Häufig wird die Federkraft vom Benutzer jedoch unkontrolliert überwunden und der Hebelziehgriff zu früh eingeschwenkt. Der Hebelziehgriff sperrt dann die Steckbaugruppe gegen das Einschieben. Ein vollständiges Einschieben der Steckbaugruppe in den Baugruppenträger ist erst nach erneutem Ausschwenken des Hebelziehgriffs, gegen die Kraft der Feder, möglich.

Es stellt sich also die Aufgabe, eine Steckbaugruppe zu schaffen, deren Hebelziehgriff in der vollständig ausgeschwenkten Position mit einfachen mechanischen Mitteln zuverlässig fixiert wird, wobei diese Fixierung beim Einschieben der Steckbaugruppe in den Baugruppenträger möglichst einfach und bequem wieder gelöst werden soll.

Bei der Lösung der Aufgabe wird von einer Steckbaugruppe zum Einstecken und Ausziehen in bzw. aus einem Baugruppenträger ausgegangen, der wenigstens eine vordere Anschlagkante aufweist. Die Steckbaugruppe umfasst einen im Frontbereich der Steckbaugruppe schwenkbar gelagerten Hebelziehgriff mit einem Griffarm und einem Hebelarm.

Gelöst wird die Aufgabe erfindungsgemäß durch einen an dem Griffarm des Hebelziehgriffs drehbar angelenkten Sperrhebel, der eine federnde Sperrzunge trägt, und eine im Frontbereich der Steckbaugruppe vorgesehene korrespondierende Sperrkontur, wobei die Sperrzunge bei vollständig ausgeschwenktem Hebelziehgriff die Sperrkontur hintergreift und dadurch den Hebelziehgriff gegen Verschwenken sperrt. Sobald der Hebelziehgriff vollständig ausgeschwenkt wird, insbesondere also beim Heraushebeln der Steckbaugruppe aus dem Baugruppenträger, hintergreift die Sperrzunge die korrespondierende Sperrkontur selbsttätig ohne manuelles Eingreifen des Benutzers. Das selbsttätige Sperren wird durch die federnde Ausführung der Sperrzunge bewirkt. Die Sperrzunge wird durch die Sperrkontur gehalten, so dass der Hebelziehgriff solange nicht mehr verschwenken kann, bis die Sperrung gelöst wird. Damit befindet sich der Hebelziehgriff automatisch in der Ausgangsposition, bei der die Steckbaugruppe ungehindert in den Baugruppenträger eingeschoben werden kann. Der Benutzer muss beim Einhebeln den Hebelziehgriff auch nicht manuell fixieren. Das Einhebeln kann deshalb auch nicht durch einen in falscher Position befindlichen Hebelziehgriff behindert werden. Dies erweist sich vor allem für den oberen Hebelziehgriff als vorteilhaft, da er sonst allein durch die Schwerkraft nach unten verschwenkt und die Steckbaugruppe gegen ein Einhebeln sperren würde.

In einer bevorzugten Ausführungsform umfasst der Sperrhebel eine Rastklinke, die zum Verrasten des vollständig eingeschwenkten Hebelziehgriffs geeignet ist, und an welcher die Sperrzunge angebracht ist. Die Rastklinke dient dazu, den vollständig eingeschwenkten Hebelziehgriff in seiner entsprechenden Endposition zu fixieren. Dies ist vor allem bei vollständig in den Baugruppenträger eingeschobenen Steckbaugruppen wünschenswert, um ein unbeabsichtigtes Heraushebeln der Steckbaugruppe zu vermeiden. Konstruktiv und herstellungstechnisch ist es vorteilhaft, wenn die Sperrzunge an der Rastklinke angeordnet ist. Beide Elemente zum Fixieren des Hebelziehgriffs bilden dann eine Einheit.

Vorteilhafterweise weist die Rastklinke eine Rastnase auf, welche hinter einer Rastkante im Frontbereich der Steckbaugruppe einrastbar ist. Die Verrastung des Sperrhebels führt dazu, dass ein unabsichtliches oder selbsttätiges Bewegen des Sperrhebels ausgeschlossen ist. Der Hebelziehgriff ist somit bei vollständig eingesteckter Steckbaugruppe gegen ein Verschwenken verriegelt. Ein Herausziehen der Steckbaugruppe aus dem Baugruppenträger ist erst nach dem Lösen der Verrastung und Entriegelung des Hebelziehgriffs möglich. Gelöst wird die Verrastung dadurch, dass die Rastnase hinter der Rastkante hervorbewegt wird. Die Rastkante im Frontbereich der Steckbaugruppe kann auf einer Leiterplatte oder auch an einem separaten Eckstück angeordnet sein.

Bevorzugt weist die Steckbaugruppe eine Frontplatte mit einer Aussparung auf. Die Aussparung der Frontplatte bildet dann die Rastkante. Durch die Aussparung hindurch greift die Rastklinke ein. Die Rastnase kann dann hinter der Rastkante einrasten. Sobald die Rastklinke durch die Aussparung der Frontplatte hindurchgreift, wird die Aussparung zu einem großen Teil verschlossen. Damit bleibt eine wichtige Funktion der Frontplatte erhalten, nämlich der Schutz der hinter der Frontplatte liegenden Bauelemente vor Beschädigungen und Verschmutzungen. Die Frontplatte kann an ihrem unteren Ende zusätzlich noch weitere Ausnehmungen aufweisen, die den unteren Bereich des Hebelziehgriffs aussparen und umformen. Damit kann ein nahezu vollständiger Abschluss der Steckbaugruppe durch die Frontplatte gewährleistet werden.

In einer besonders vorteilhaften Ausbildung der Steckbaugruppe betätigt die Rastklinke bei vollständig eingesteckter Steckbaugruppe einen Schalter zur Aktiv-Passiv-Schaltung der Steckbaugruppe. Zusätzlich zum Verriegeln des Hebelziehgriffs bei komplett eingesteckter Steckbaugruppe und vollständig eingeschwenktem Hebelziehgriff kann die Steckbaugruppe durch Betätigung eines Schalters aktiviert bzw. passiv geschaltet werden. Dies ist insbesondere bei Computersystemen wichtig, damit nur stromlose Steckbaugruppen aus dem Baugruppenträger heraus bzw. in den Baugruppenträger hinein geschoben werden. Erst nach vollständigem Einstecken der Steckbaugruppe wird diese aktiv geschaltet. Damit werden Störungen des internen Bussystems zuverlässig verhindert. Da die Rastklinke die Betätigung des Schalters vornimmt, ist das Schalten der Steckbaugruppe mit der Verriegelung des Sperrhebels bzw. des Hebelziehgriffs gekoppelt. Es ist also unmöglich, eine nicht passiv geschaltete Steckbaugruppe aus dem Baugruppenträger zu entfernen, da gleichzeitig mit der Entriegelung automatisch auch der Schalter zur Aktiv-Passiv-Schaltung betätigt wird. Um ein optimales und zuverlässiges Schalten der Steckbaugruppe zu gewährleisten, kann die Form der Schaltklinke an den Schalter angepasst sein, beispielsweise durch Ausbildung einer Schaltfläche oder einer Schaltnocke am freien Ende der Rastklinke.

In einer weiteren vorteilhaften Ausführungsform der erfindungsgemäßen Steckbaugruppe wirkt ein Betätigungselement auf die Sperrzunge. Das Betätigungselement wirkt mit der vorderen Anschlagkante des Baugruppenträgers derart zusammen, dass beim Einschieben der Steckbaugruppe der Hebelziehgriff selbsttätig entsperrt wird. Sobald das Betätigungselement beim Einschieben der Steckbaugruppe in den Baugruppenträger mit der Anschlagkante in Kontakt kommt, drückt es auf die Sperrzunge, die sich dadurch von der Sperrkontur löst und den Hebelziehgriff freigibt. Damit wird der in seiner ausgeschwenkten Endposition fixierte Hebelziehgriff entsperrt, so dass das Einschieben nicht durch den ausgeschwenkten Hebelziehgriff behindert wird. Das selbsttätige Entsperren des Hebelziehgriffs in seiner vollständig ausgeschwenkten Position wird beim Einschieben der Steckbaugruppe ohne manuelles Eingreifen des Benutzers vorgenommen. Die Handhabbarkeit für den Benutzer wird dadurch optimiert.

Das Betätigungselement kann vorteilhaft als Verlängerung der Sperrzunge ausgebildet sein und am Hebelarm des Hebelziehgriffs unter Vorspannung anliegen. Die Sperrzunge ist derart ausgebildet, dass sie bei Erreichen der ausgeschwenkten Endposition selbsttätig die Sperrkontur hintergreift. Durch die Vorspannung wird nun das Sperren des Hebelziehgriffs in der ausgeschwenkten Endposition unterstützt. Die Vorspannung unterstützt ferner auch die Verrastung des vollständig eingeschwenkten Hebelziehgriffs bei eingeschobener Steckbaugruppe, indem die Rastnase federnd gegen die Rastkante gezogen wird. Zum Lösen der Verrastung muss, genau wie zum Entsperren in der ausgeschwenkten Position des Hebelziehgriffs, die Vorspannung des Betätigungselements überwunden werden. Ein versehentliches Lösen der Sperrung wie auch der Verrastung des Hebelziehgriffs ist damit ausgeschlossen.

Bevorzugt ist das Betätigungselement längsverschieblich am Hebelarm gelagert. Damit wird bei platzsparender Anordnung eine effektive Wirkung realisiert, bei der das Betätigungselement lediglich über einen kurzen Weg bewegt werden muss. Das längsverschieblich gelagerte Betätigungselement entfaltet besonders beim Entsperren, das heißt, wenn die Sperrzunge mit der Sperrkontur außer Eingriff kommt, eine gute Kraftwirkung und Übertragung. Die Längsverschiebung des Betätigungselements wird dabei in eine Drehung des Sperrhebels bezüglich des Hebelziehgriffs umgesetzt.

Besonders bevorzugt weist der Sperrhebel einen Betätigungsarm auf. Der Betätigungsarm ermöglicht es dem Benutzer, den Sperrhebel manuell zu bewegen und dadurch den vollständig ausgeschwenkten Hebelziehgriff zu entsperren bzw. den eingeschwenkten Hebelziehgriff aus seiner Verrastung zu lösen. Neben der Entriegelung des Hebelziehgriffs hat der Betätigungsarm weiterhin die Funktion, den Hebelziehgriff anzupacken.

In einer besonders vorteilhaften Ausführung hat der Betätigungsarm einen U-förmigen Querschnitt, zwischen dessen U-Schenkeln der Griffarm des Hebelziehgriffs einschwenkbar ist. Der U-förmige Betätigungsarm umgreift dann den Griffarm des Hebelziehgriffs teilweise und führt diesen zwischen seinen beiden U-Schenkeln. Dadurch wird die Beweglichkeit des Sperrhebels auf die Vorzugsrichtung beschränkt. Die Stabilität des Sperrhebels gegen Seitenkräfte wird vergrößert. Ein Verdrehen des Sperrhebels gegen den Hebelziehgriff wird durch die U-förmige Führung verhindert. Die Handhabbarkeit für den Benutzer wird optimiert. Der U-förmig ausgebildete Betätigungsarm ist deutlich breiter als der Hebelziehgriff. Das manuelle Betätigen des Betätigungsarms durch den Benutzer wird dadurch komfortabler.

Alternativ könnte auch der Griffarm des Hebelziehgriffs U-förmig ausgebildet sein. Der Betätigungsarm würde dann zwischen den U-Schenkeln des Hebelziehgriffs geführt. Bei einer solchen Ausführung könnte der Betätigungsarm des Sperrhebels zusätzlich T-förmig ausgebildet sein, so dass dann der T-Rücken eine breite Auflagefläche zur komfortablen Betätigung durch den Benutzer bereitstellte.

Der U-Rücken des Betätigungsarms ist zweckmäßig zur Steckbaugruppe hin ausgerichtet, wodurch der Bedienkomfort des Hebels verbessert wird. Bei der Bedienung drückt der Benutzer den Betätigungsarm des Sperrhebels gegen den Griffarm des Hebelziehgriffs. Bei vollständig in den Baugruppenträger eingeschobener Steckbaugruppe bewirkt diese Relativbewegung des Sperrhebels das Lösen der Verrastung des Hebelziehgriffs. Sobald der Betätigungsarm des Sperrhebels am Griffarm des Hebelziehgriffs anliegt, wird die auf den Betätigungsarm ausgeübte Kraft direkt auf den Griffarm des Hebelziehgriffs übertragen, und die Schwenkbewegung des Hebelziehgriffs und damit das Aushebeln der Steckbaugruppe aus dem Baugruppenträger beginnt.

Vorzugsweise weist die Steckbaugruppe eine Frontplatte auf, die ein abgewinkeltes, im Wesentlichen ebenes Seitenteil umfasst. Der Eckbereich des Seitenteils kann als Sperrkontur ausgebildet sein. Das ist einfach herzustellen. Darüber hinaus erweist sich eine derart realisierte Sperrkontur als außerordentlich stabil, besonders, wenn die Frontplatte aus Metall hergestellt ist. Ein Verschleiß durch Abreibung oder Abknicken der Sperrkontur ist dann ausgeschlossen. Eine besonders gute Wirkung beim Sperren des Hebelziehgriffs entfaltet die an dem Seitenteil angeordnete Sperrkontur, wenn das Seitenteil auch das Lager für den Hebelziehgriff trägt. Dann ist ein direktes Zusammenwirken zwischen der Sperrzunge, die am Hebelziehgriff angeordnet und damit ebenfalls am Seitenteil gelagert ist, und der Sperrkontur gewährleistet. Sperrzunge und Sperrkontur können sehr exakt und ohne großes Spiel aufeinander abgestimmt werden. Geringe Toleranzen sind möglich. Dies sichert ein reibungsloses Zusammenspiel der bewegten Teile.

In einer vorteilhaften Ausführungsform ist im Eckbereich der Frontplatte ein spezielles Eckstück vorgesehen, an dem der Hebelziehgriff schwenkbar gelagert und an dem die Sperrkontur ausgebildet ist. Das Eckstück ist als ein separates Teil ausgebildet. Es kann aus einem anderen Material gestaltet sein als die Frontplatte der Steckbaugruppe. Vorteilhaft ist ein solches separates Eckstück besonders dann, wenn andere Hebel eingesetzt oder spezielle Hebel nachträglich nachgerüstet werden sollen. Da immer sowohl der Hebelziehgriff als auch die Sperrkontur am Eckstück angeordnet sind, findet eine sehr direkte Wirkung zwischen beiden statt, was ein zuverlässiges Sperren des Hebelziehgriffs gewährleistet.

Ein Ausführungsbeispiel der Erfindung wird nachstehend anhand der beigefügten Abbildungen näher erläutert. Es zeigen:
- Figuren 1a bis 1e: den vorderen Bereich einer Steckbaugruppe mit einem Hebelziehgriff und daran angelenktem Sperrhebel, in unterschiedlichen Stellungen beim Herausziehen der Steckbaugruppe aus einem Baugruppenträger, jeweils als seitliches Schnittbild;
- Figuren 2a bis 2e: den vorderen Eckbereich der Steckbaugruppe, in unterschiedlichen Stellungen beim Hineinhebeln der Steckbaugruppe in den Baugruppenträger, jeweils als Schnittbild;
- Figur 3: eine perspektivische Darstellung des Sperrhebels aus Figur 1a;
- Figur 4: eine perspektivische Darstellung des Hebelziehgriffs aus Figur 1a;
- Figuren 5a und 5b: eine perspektivische Darstellung des vorderen Eckbereichs der Steckbaugruppe aus Figur 1a;
- Figur 6a: das untere Ende der Frontplatte der Steckbaugruppe aus Figur 5a, in perspektivischer Darstellung von innen;
- Figur 6b: die Frontplatte von Fig. 6a, von außen;
- Figuren 7a und 7b: eine alternative Ausführungsform des unteren Eckbereichs einer Steckbaugruppe mit einer Frontplatte und einem Eckstück, in perspektivischer Darstellung ;
- Figuren 8a und 8b: die Frontplatte aus Figur 7a allein;
- Figuren 9a und 9b: das Eckstück aus Figur 7a, allein.

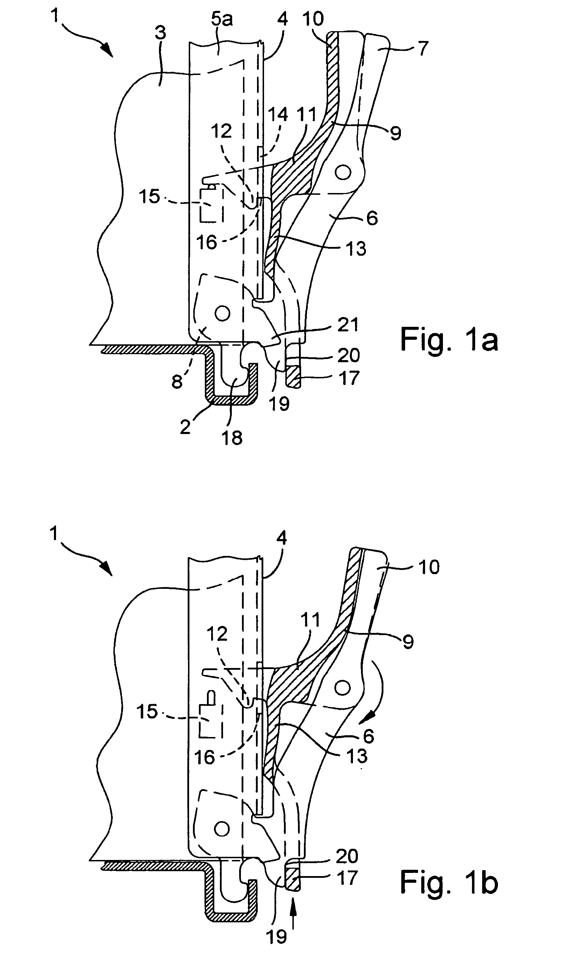

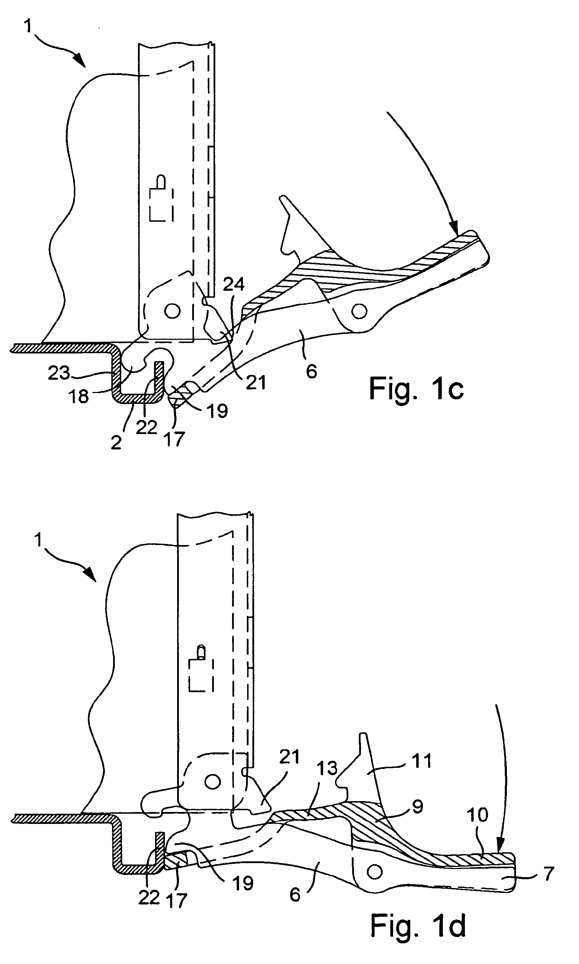

Die Figuren 1a bis 1d verdeutlichen den Vorgang des Ausziehens einer Steckbaugruppe 1 aus einem Baugruppenträger. Vom Baugruppenträger ist lediglich die untere vordere Anschlagkante 2 zu sehen, die beispielsweise von einer Profilschiene bzw. Modulschiene gebildet wird.

Figur 1a zeigt die Steckbaugruppe 1 in vollständig in den Baugruppenträger eingesteckter Position. Die Steckbaugruppe 1 umfasst eine Leiterplatte 3, eine Frontplatte 4 mit abgewinkeltem Seitenteil 5a und einen im Frontbereich der Steckbaugruppe 1 drehbar angeordneten Hebelziehgriff 6. Der Hebelziehgriff 6 hat einen langen, nach oben gestreckten Griffarm 7 und einen kürzeren Hebelarm 8.

Am Griffarm 7 ist ein Sperrhebel 9 drehbar angelenkt. Der Sperrhebel 9 umfasst einen Betätigungsarm 10 und eine Rastklinke 11, die in etwa im 90-Grad-Winkel zum Betätigungsarm 10 angeordnet ist. An der Rastklinke 11 ist eine Rastnase 12 angeformt. Weiterhin ist an der Rastklinke 11 eine Sperrzunge 13 angebracht, die in etwa parallel zur Frontplatte 4 nach unten verläuft. Bei vollständig in den Baugruppenträger eingesteckter Steckbaugruppe 1 ragt die Rastklinke 11 durch eine Aussparung 14 der Frontplatte 4 hindurch und betätigt einen hinter der Frontplatte 4 angeordneten Schalter 15 zur Aktiv-Passiv-Schaltung der auf der Steckbaugruppe 1 angeordneten elektronischen Schaltung. Die Rastnase 12 der Rastklinke 11 verrastet dabei hinter einer Rastkante 16 der Aussparung 14.

Als Verlängerung der Sperrzunge 13 ist ein Betätigungselement 17 angeformt, das ähnlich einer Kufe ausgebildet ist und sich nach unten erstreckt. Das freie Ende des Betätigungselements 17 überragt den Hebelarm 8 nach unten.

Der Hebelarm 8 umfasst einen Sporn 18, der mit der Anschlagkante 2 bei vollständig in den Baugruppenträger eingesteckter Steckbaugruppe 1 in Eingriff ist, und eine Abdrückschulter 19, die an ihrer Außenseite eine Abdrückfläche 20 aufweist. An der Abdrückfläche 20 liegt das Betätigungselement 17 unter Vorspannung an.

Das Seitenteil 5a der Frontplatte 4 weist an seinem unteren Ende eine Sperrkontur 21 auf, die das Seitenteil 5a nach vorne überragt.

In Figur 1b ist der Beginn des Ausziehens der Steckbaugruppe 1 aus dem Baugruppenträger dargestellt. Der Sperrhebel 9 ist derart verschwenkt, dass der Betätigungsarm 10 am Griffarm 7 anliegt. Dadurch wird das freie Ende der Rastklinke 11 angehoben. Die Rastnase 12 löst sich von der Rastkante 16, wodurch die Verrastung des Sperrhebels 9 und damit die Verriegelung des Hebelziehgriffs 6 aufgehoben wird. Gleichzeitig wird der Schalter 15 freigegeben, so dass die Steckbaugruppe 1 passiv geschaltet wird. Die Bewegung der Rastklinke 11 hat zur Folge, dass die Sperrzunge 13 entlang der Frontplatte 4 nach oben bewegt wird.

Der entriegelte Hebelziehgriff 6 kann nun in Pfeilrichtung ausgeschwenkt werden, wodurch die Steckbaugruppe 1 aus dem Baugruppenträger ausgehebelt wird (Figur 1c). Der Sporn 18 greift an einem Innenschenkel 23 der Anschlagkante 2 an. Während des Verschwenkens des Hebelziehgriffs 6 liegt das Betätigungselement 17 an einer Ecke 24 der Sperrkontur 21 an und gleitet an dieser entlang.

In Figur 1d ist der Hebelziehgriff 6 vollständig ausgeschwenkt. Die Abdrückschulter 19 liegt nun am Außenschenkel 22 der Anschlagkante 2 an.

Da der Betätigungsarm 10 des Sperrhebels 9 gegen den Griffarm 7 des Hebelziehgriffs 6 drückt, ist die Sperrzunge 13 in Richtung des Rastelements 11 verschoben, so dass sie nicht mehr in Eingriff mit der Sperrkontur 21 ist.

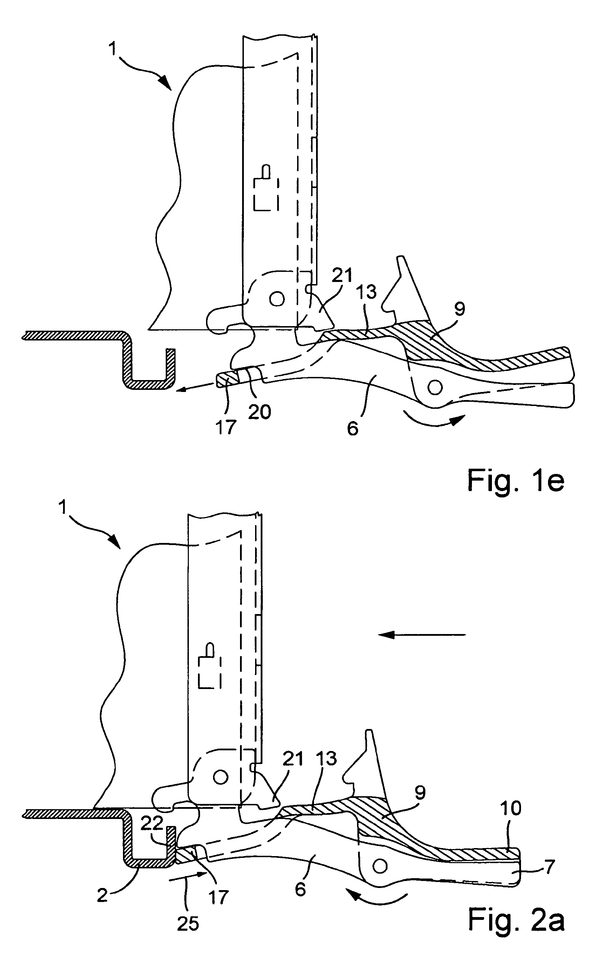

Wird nun, nach erfolgtem Aushebeln der Steckbaugruppe 1 aus dem Baugruppenträger, der Betätigungsarm 10 vom Benutzer losgelassen, dreht der Sperrhebel 9 in seine Ruhelage auf dem Hebelziehgriff 6 zurück. Am Ende hintergreift die Sperrzunge 13 die Sperrkontur 21, wodurch der Hebelziehgriff 6 gegen Verschwenken gesperrt wird. Diese Position der Steckbaugruppe 1 ist in Figur 1e dargestellt; sie ist gleichzeitig die Ausgangsposition, aus der die Steckbaugruppe 1 wieder in den Baugruppenträger eingehebelt werden kann.

Zum Einhebeln der Steckbaugruppe 1 wird diese zunächst so weit in den Baugruppenträger hineingeschoben, bis das Betätigungselement 17 an den Außenschenkel 22 der Anschlagkante 2 des Baugruppenträgers anstößt. Das weitere Einschieben der Steckbaugruppe 1 gemäß Figur 2a hat zur Folge, dass das Betätigungselement 17 in Pfeilrichtung 25 gedrückt wird. Die Sperrzunge 13 wird dadurch an der Sperrkontur 21 entlang geschoben, bis die Sperrzunge 13 und die Sperrkontur 21 außer Eingriff kommen. Der Hebelziehgriff 6 ist damit entsperrt und lässt sich nach oben in Richtung zur Frontplatte 4 hin verschwenken, um die Steckbaugruppe 1 einzuhebeln.

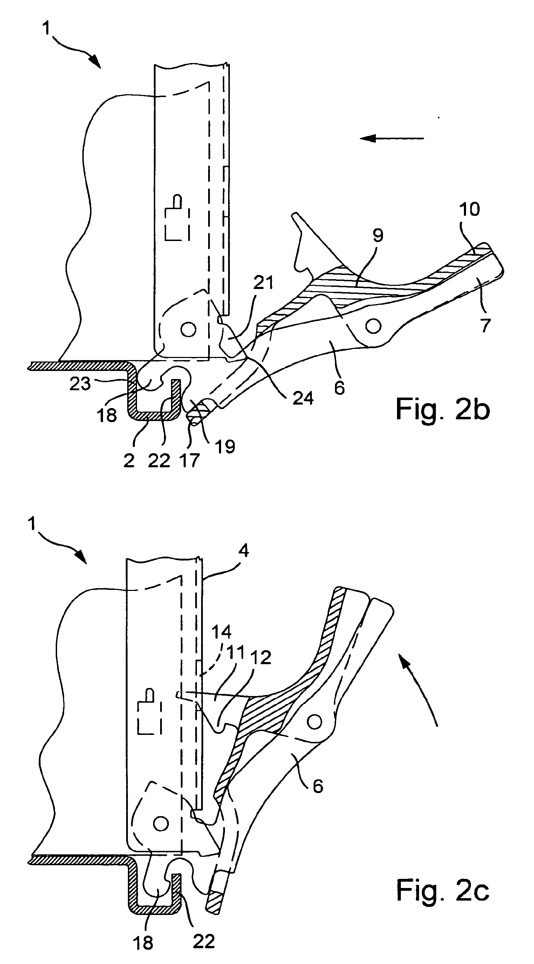

Figur 2b zeigt die teilweise eingeschobene Steckbaugruppe 1 mit teilweise eingeschwenktem Hebelziehgriff 6. Der Hebelziehgriff 6 ist soweit verschwenkt, dass die Abdrückschulter 19 in Eingriff mit dem Außenschenkel 22 der Anschlagkante 2 kommt. Der Sperrhebel 9 ist durch seine federnde Vorspannung in seine Ruheposition zurückgekehrt.

In Figur 2c ist der Hebelziehgriff 6 soweit verschwenkt, dass nun der Sporn 18 an der Innenseite des Außenschenkels 22 angreift, so dass die Steckbaugruppe 1 in den Baugruppenträger eingehebelt werden kann. Die Rastklinke 11 greift bereits ein Stück in die Aussparung 14 der Frontplatte 4 ein; die Rastnase 12 befindet sich jedoch noch außerhalb der Frontplatte 4.

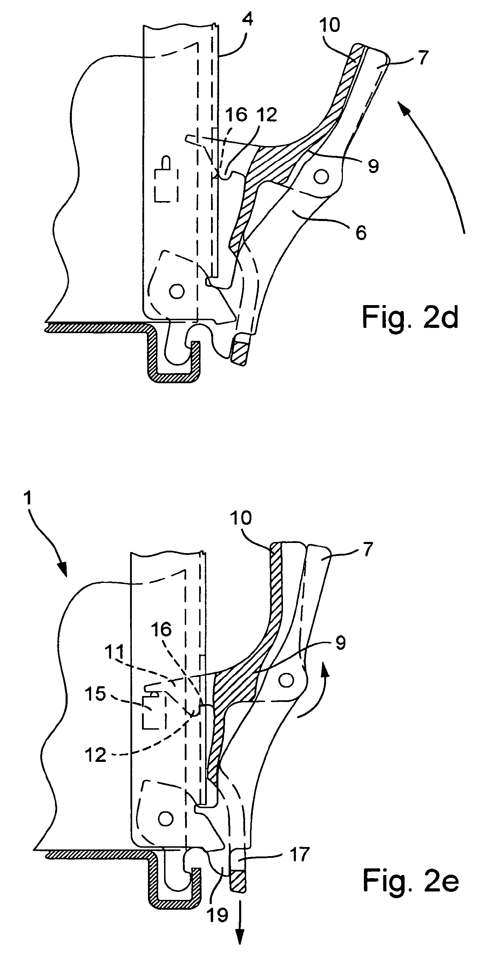

Beim weiteren Verschwenken des Hebelziehgriffs 6, wie in Figur 2d dargestellt, setzt die Rastnase 12 auf der Rastkante 16 der Frontplatte 4 auf, wodurch der Betätigungsarm 10 des Sperrhebels 9 in Richtung des Griffarms 7 des Hebelziehgriffs 6 gedreht wird.

Bei vollständig in den Baugruppenträger eingesteckter Steckbaugruppe 1, wie in Figur 2e zu sehen, ist die Rastnase 12 hinter der Rastkante 16 eingerastet. Die Rastklinke 11 drückt mit ihrem freien Ende auf den Schalter 15, wodurch die Steckbaugruppe 1 aktiv geschaltet wird. Das Einschnappen der Rastnase 12 hinter die Rastkante 16 bewirkt eine schnelle Drehung des Sperrhebels 9 zurück in seine Ruheposition, bei der der Betätigungsarm 10 vom Griffarm 7 absteht. Die Steckbaugruppe 1 ist nun vollständig in den Baugruppenträger eingeschoben.

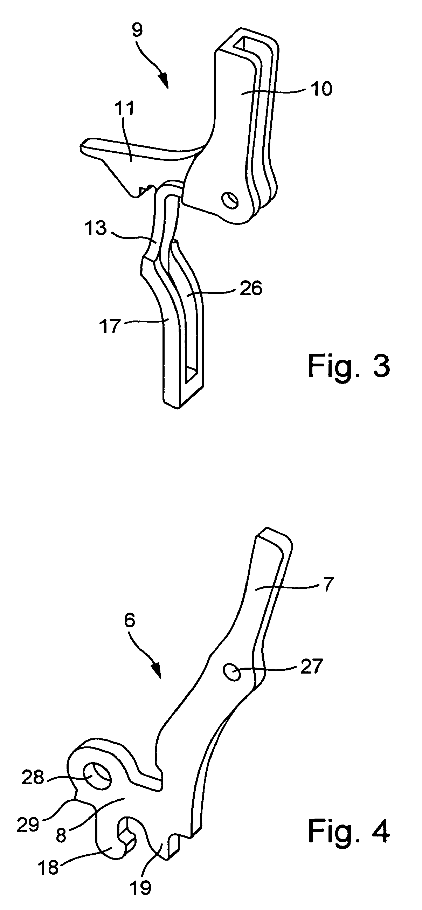

Figur 3 zeigt den Sperrhebel 9 im Detail. In dieser Ausführungsform ist die Sperrzunge 13 nicht direkt an der Rastklinke 11 angeordnet, sondern am unteren Ende des Betätigungsarms 10. Der Betätigungsarm 10 ist im Querschnitt U-förmig ausgebildet. Zwischen seine beiden U-Schenkel kann der Griffarm 7 des Hebelziehgriffs 6 (vgl. Fig. 4) eingeschwenkt werden. An der Sperrzunge 13 ist das Betätigungselement 17 als Verlängerung angeformt. Das Betätigungselement 17 weist eine Ausnehmung 26 auf, durch die der Hebelziehgriff 6 teilweise hindurchgreifen kann. Der U-Rücken des Betätigungsarms 10 ist deutlich breiter als der Griffarm 7 des Hebelziehgriffs 6.

Der Hebelziehgriff 6 ist in Figur 4 herausgezeichnet. Er weist etwa in der Mitte seines Griffarms 7 eine Bohrung 27 auf, die mit den Bohrungen in den U-Schenkeln des Betätigungsarms 10 des Sperrhebels 9 (vgl. Fig. 3) korrespondiert und mit diesen ein Drehlager bildet, so dass der Sperrhebel 9 auf dem Hebelziehgriff 6 schwenkbeweglich gelagert ist. Der Hebelarm 8 mit dem Sporn 18 und der Abdrückschulter 19 hat ferner eine Lagerbohrung 28, die das Drehlager zum Verschwenken des Hebelziehgriffs 6 selbst bildet. Unterhalb der Lagerbohrung 28 ist ein Absatz 29 angeordnet, die gemeinsam mit einem Anschlag eine Begrenzung der Drehbewegung des Hebelgriffs 6 bewirkt.

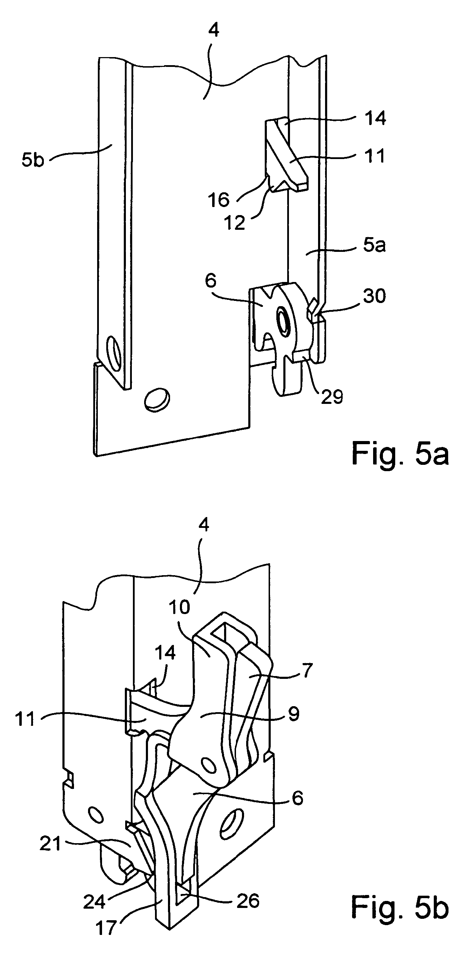

In Figur 5a ist die Frontplatte 4 mit ihren beiden Seitenteilen 5a, 5b von innen, also von der Steckbaugruppe 1 her, zu sehen, und zwar bei vollständig eingeschwenktem Hebelziehgriff 6. Durch die Aussparung 14 greift die Rastklinke 11 hindurch. Die Rastnase 12 der Rastklinke 11 ist hinter der Rastkante 16 verrastet. Am unteren Ende des Seitenteils 5a ist der Hebelziehgriff 6 drehbar gelagert. Ebenfalls im unteren Bereich des Seitenteils 5a ist ein Anschlag 30 ausgeformt. Bei vollständig ausgeschwenktem Hebelziehgriff 6 begrenzt der Anschlag 30 gemeinsam mit dem Absatz 29 den Drehwinkel des Hebelziehgriffs 6 und legt somit dessen maximal ausgeschwenkte Position fest.

Figur 5b zeigt die Frontplatte 4 von außen, mit dem Hebelziehgriff 6 und dem darauf montierten Sperrhebel 9. Der Betätigungsarm 10 des Sperrhebels 9 umgreift mit seinen U-Schenkeln den Griffarm 7 des Hebelziehgriffs 6. Die Rastklinke 11 greift durch die Aussparung 14 der Frontplatte 4 hindurch. Der Hebelziehgriff 6 greift durch die Ausnehmung 26 des Betätigungselements 17 hindurch.

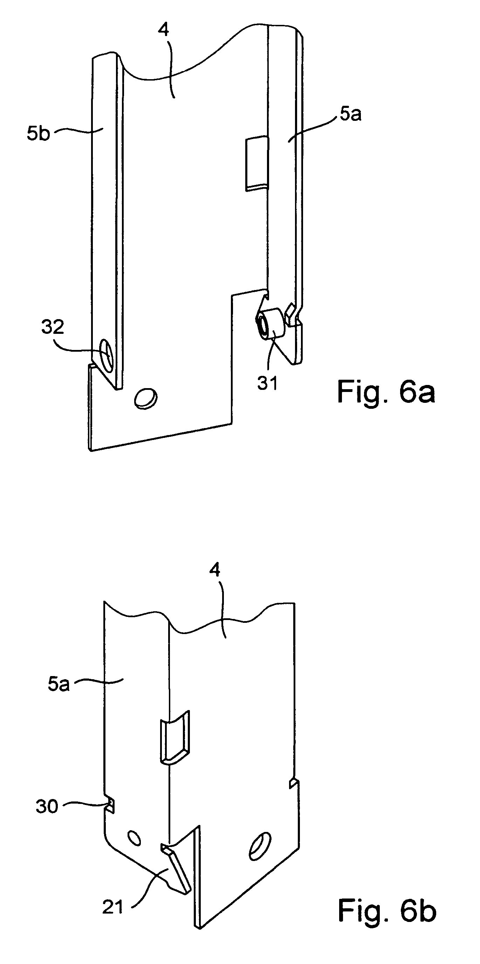

In Figur 6a ist die Frontplatte 4 von innen zu sehen, ohne Hebelziehgriff. Am unteren Ende des Seitenteils 5a ist ein Flansch 31 angeordnet, der den Hebelziehgriff aufnimmt. Der Flansch 31 trägt ein (nicht dargestelltes) Innengewinde, so dass der Hebelziehgriff durch eine Schraube gesichert werden kann. Außerdem wird die Leiterplatte der Steckbaugruppe an dem Flansch 31 befestigt. Mit dem Flansch 31 fluchtet eine Bohrung 32 im Seitenteil 5b der Frontplatte 4, so dass ein Schraubendreher durch die Bohrung 32 hindurchgeführt und eine Schraube in den Flansch 31 eingeschraubt werden kann.

In Figur 6b ist die Frontplatte 4 ist von vorne gezeigt. Am unteren Ende des Seitenteils 5a ist die Sperrkontur 21 angeformt. Sie ragt über die Frontplatte 4 nach vorne hinaus. An der hinteren Kante des Seitenteils 5a ist der Anschlag 30 zu erkennen, der nach innen gerichtet ist. Diese so ausgebildete Frontplatte 4 mit den Seitenteilen 5a, 5b und der Sperrkontur 21 lässt sich durch Ausstanzen und Umbiegen der Seitenteile 5a, 5b einstückig herstellen.

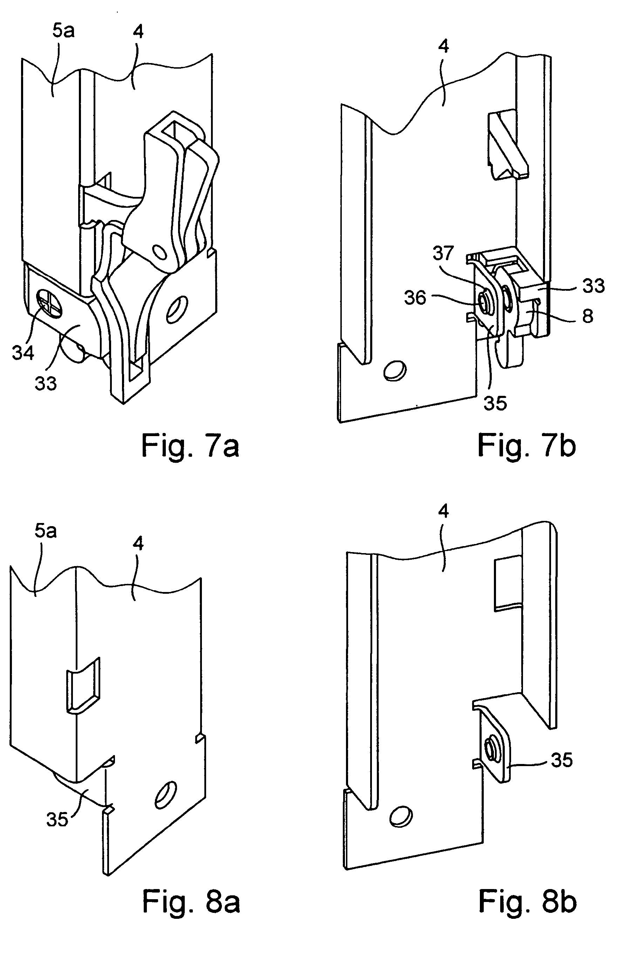

Eine alternative Ausführungsform der Frontplatte 4 ist in Figur 7a gezeigt. Im unteren Bereich der Frontplatte 4 ist ein Eckstück 33 mit einer Schraube 34 an der Frontplatte 4 montiert. Das Eckstück 33 ist in Verlängerung des Seitenteils 5a angeordnet.

Die Innenseite der Frontplatte 4 gemäß Figur 7a ist in Figur 7b zu sehen. Die Frontplatte 4 weist ein um 90 Grad nach innen abgewinkeltes Aufnahmeblech 35 auf. Das Aufnahmeblech 35 hat eine Bohrung 36, die von einem Kragen 37 umformt ist. Die Bohrung 36 trägt ein (nicht dargestelltes) Innengewinde, in das die Schraube zur Halterung des Eckstücks 33 eingeschraubt wird. Das Eckstück 33 umgreift den Hebelarm 8 des Hebelziehgriffs 6. Die Lagerbohrung 28 im Hebelarm 8 fluchtet mit der Bohrung 36 des Aufnahmeblechs 35. Das Eckstück 33 und der Hebelarm 8 sind von dem Aufnahmeblech 35 beabstandet, so dass in den Zwischenraum die Leiterplatte der Steckbaugruppe eingeschoben werden kann. Die Leiterplatte wird dann ebenfalls mit der Schraube zur Halterung des Eckstücks 33 gehalten.

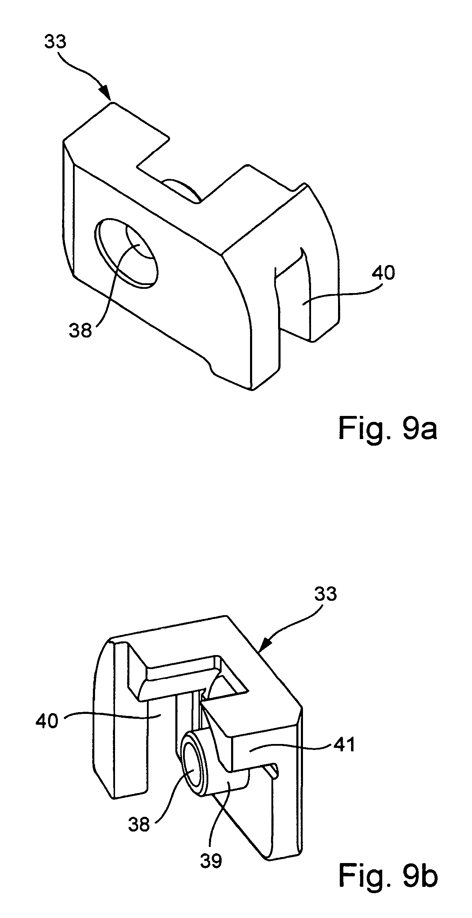

In Figur 8a ist die Frontplatte 4 gemäß Figur 7a allein dargestellt. Das Seitenteil 5a ist um die Höhe des Aufnahmeblechs 35 verkürzt und bietet somit Platz für die Aufnahme des Eckstücks. Die Innenansicht ist in Figur 8b gezeigt. Das Aufnahmeblech 35 ragt senkrecht nach innen und ist parallel zu den Seitenteilen 5a, 5b ausgerichtet.

Das Eckstück 33 ist in den Figuren 9a und 9b in perspektivischer Darstellung gezeigt. Eine Bohrung 38 ist auf der Längsseite des Eckstücks 33 angeordnet. Die Bohrung 38 durchstößt eine Hülse 39 an der Innenseite des Eckstücks 33. Die Hülse 39 dient zur Aufnahme des Hebelziehgriffs, der in einer Nut 40 geführt wird. An der vorderen oberen Ecke des Eckstücks 33 ist ein Stopper 41 ausgebildet, der den maximalen Drehwinkel des Hebelziehgriffs begrenzt.

### Zusammenstellung der Bezugszeichen

- 1: Steckbaugruppe
- 2: Anschlagkante
- 3: Leiterplatte
- 4: Frontplatte
- 5a, 5b: Seitenteile (von 4)
- 6: Hebelziehgriff
- 7: Griffarm (von 6)
- 8: Hebelarm (von 6)
- 9: Sperrhebel
- 10: Betätigungsarm (von 9)
- 11: Rastklinke (an 9)
- 12: Rastnase (an 9)
- 13: Sperrzunge (an 11)
- 14: Aussparung (in 4)
- 15: Schalter
- 16: Rastkante
- 17: Betätigungselement
- 18: Sporn
- 19: Abdrückschulter
- 20: Abdrückfläche
- 21: Sperrkontur
- 22: Außenschenkel (von 2)
- 23: Innenschenkel (von 2)
- 24: Ecke (von 21)
- 25: Pfeil
- 26: Ausnehmung
- 27: Bohrung (in 6)
- 28: Lagerbohrung (in 6)
- 29: Absatz
- 30: Anschlag
- 31: Flansch
- 32: Bohrung (in 5b)
- 33: Eckstück
- 34: Schraube
- 35: Aufnahmeblech
- 36: Bohrung (in 35)
- 37: Kragen
- 38: Bohrung
- 39: Hülse
- 40: Nut
- 41: Stopper

## Patentansprüche

1. Steckbaugruppe (1) zum Einstecken und Ausziehen in bzw. aus einem Baugruppenträger, der wenigstens eine vordere Anschlagkante (2) aufweist, mit einem im Frontbereich der Steckbaugruppe schwenkbar gelagerten Hebelziehgriff (6) mit einem Griffarm (7) und einem Hebelarm (8);
**dadurch gekennzeichnet, dass**
- an dem Griffarm (7) des Hebelziehgriffs (6) ein Sperrhebel (9) drehbar angelenkt ist;
- der Sperrhebel (9) eine federnde Sperrzunge (13) trägt;
- im Frontbereich der Steckbaugruppe (1) eine korrespondierende Sperrkontur (21) vorgesehen ist; und
- die Sperrzunge (13) bei vollständig ausgeschwenktem Hebelziehgriff (6) die Sperrkontur (21) hintergreift und **dadurch** den Hebelziehgriff (6) gegen Verschwenken sperrt.

2. Steckbaugruppe nach Anspruch 1, **dadurch gekennzeichnet, dass**
- der Sperrhebel (9) eine Rastklinke (11) umfasst, die zum Verrasten des vollständig eingeschwenkten Hebelziehgriffs (6) dient; und
- die Sperrzunge (13) an der Rastklinke (11) angebracht ist.

3. Steckbaugruppe nach Anspruch 2, **dadurch gekennzeichnet, dass** die Rastklinke (11) eine Rastnase (12) aufweist, die hinter einer Rastkante (16) im Frontbereich der Steckbaugruppe (1) einrastbar ist.

4. Steckbaugruppe nach Anspruch 3, **gekennzeichnet durch** eine Frontplatte (4) mit einer Aussparung (14), welche die Rastkante (16) bildet und **durch** welche die Rastklinke (11) hindurchgreift.

5. Steckbaugruppe nach einem der Ansprüche 2 bis 4, **dadurch gekennzeichnet, dass** die Rastklinke (11) bei vollständig eingesteckter Steckbaugruppe (1) einen Schalter (15) zur Aktiv-Passiv-Schaltung der Steckbaugruppe (1) betätigt.

6. Steckbaugruppe nach einem der Ansprüche 1 bis 5, **dadurch gekennzeichnet, dass** auf die Sperrzunge (13) ein Betätigungselement (17) wirkt, das mit der vorderen Anschlagkante (2) des Baugruppenträgers derart zusammenwirkt, dass beim Einschieben der Steckbaugruppe (1) der Hebelziehgriff (6) selbsttätig entsperrt wird.

7. Steckbaugruppe nach Anspruch 6, **dadurch gekennzeichnet, dass** das Betätigungselement (17) als Verlängerung der Sperrzunge (13) ausgebildet ist und am Hebelarm (8) des Hebelziehgriffs (6) unter Vorspannung anliegt.

8. Steckbaugruppe nach Anspruch 6 oder 7, **dadurch gekennzeichnet, dass** das Betätigungselement (17) längs verschieblich am Hebelarm (8) gelagert ist.

9. Steckbaugruppe nach einem der Ansprüche 1 bis 8, **dadurch gekennzeichnet, dass** der Sperrhebel (9) einen Betätigungsarm (10) umfasst.

10. Steckbaugruppe nach Anspruch 9, **dadurch gekennzeichnet, dass** der Betätigungsarm (10) einen U-förmigen Querschnitt hat, zwischen dessen U-Schenkeln der Griffarm (7) des Hebelziehgriffs (6) einschwenkbar ist.

11. Steckbaugruppe nach einem der Ansprüche 1 bis 10, **dadurch gekennzeichnet, dass** eine Frontplatte (4) ein abgewinkeltes, im Wesentlichen ebenes Seitenteil (5a) umfasst, dessen Eckbereich als Sperrkontur (21) ausgebildet ist.

12. Steckbaugruppe nach einem der Ansprüche 1 bis 10, **dadurch gekennzeichnet, dass** im Eckbereich einer Frontplatte (4) ein Eckstück (33) vorgesehen ist, an dem der Hebelziehgriff (6) schwenkbar gelagert ist und an dem die Sperrkontur (21) ausgebildet ist.

## Claims

1. Plug-in assembly (1) for insertion into and/or withdrawal from an assembly support which has at least one front stop edge (2), with a pulling lever which is pivotably mounted in the front region of the plug-in assembly and has a gripping arm (7) and a lever arm (8),
**characterised in that**
- a locking lever (9) is rotatably articulated on the gripping arm (7) of the pulling lever (6);
- the locking lever (9) bears a resilient locking tab (13);
- a corresponding locking contour (21) is provided in the front region of the plug-in assembly; and
- the locking tab (13) engages behind the locking contour (21) when the pulling lever (6) is completely pivoted out and thereby locks the pulling lever (6) against pivoting.

2. Plug-in assembly as claimed in Claim 1, **characterised in that**
- the locking lever (9) comprises a detent (11) which serves for latching the pulling lever (9) when it is completely pivoted in; and
- the locking tab (13) is attached to the detent (11).

3. Plug-in assembly as claimed in Claim 2, **characterised in that** the detent (11) has a detent lug (12) which can engage behind a detent edge (16) in the front region of the plug-in assembly (1).

4. Plug-in assembly as claimed in Claim 3, **characterised by** a front plate (4) with a recess (14) which forms the detent edge (16) and through which the detent (11) engages.

5. Plug-in assembly as claimed in any one of Claims 2 to 4, **characterised in that** when the plug-in assembly (1) is completely inserted the detent (11) actuates a switch (15) for the active/passive switching of the plug-in assembly (1).

6. Plug-in assembly as claimed in any one of Claims 1 to 5, **characterised in that** the locking tab (13) is acted upon by an actuating element (17) which co-operates with the front stop edge (2) of the assembly support in such a way that that the pulling lever (6) is automatically unlocked during the insertion of the plug-in assembly (1).

7. Plug-in assembly as claimed in Claim 6, **characterised in that** the actuating element (17) is constructed as an extension of the locking tab (13) and rests under pretension against the lever arm (8) of the pulling lever (6).

8. Plug-in assembly as claimed in Claim 6 or 7, **characterised in that** the actuating element (17) is mounted on the lever arm (8) so as to be longitudinally displaceable.

9. Plug-in assembly as claimed in any one of Claims 1 to 8, **characterised in that** the locking lever (9) comprises an actuating arm (10).

10. Plug-in assembly as claimed in Claim 9, **characterised in that** the actuating arm (10) has a U-shaped cross-section and that the gripping arm (7) of the pulling lever (6) can be pivoted in between the legs of the U.

11. Plug-in assembly as claimed in any one of Claims 1 to 10, **characterised in that** a front plate (4) comprises an angled substantially level side part (5a), the corner region of which is constructed as a locking contour (21).

12. Plug-in assembly as claimed in any one of Claims 1 to 10, **characterised in that** in the corner region of a front plate (4) a corner piece (33) is provided on which the pulling lever (6) is pivotably mounted and on which the locking contour (21) is formed.

## Revendications

1. Unité enfichable (1) à insérer dans ou à extraire d'une baie, qui présente au moins une arête de butée antérieure (2), comportant une poignée de traction à levier (6) supportée de manière pivotante dans une zone frontale de l'unité enfichable, présentant un bras de poignée (7) et un bras de levier (8),
**caractérisée en ce que**
- un levier d'arrêt (9) est articulé de manière pivotante sur le bras de poignée (7) de la poignée de traction à levier (6) ;
- le levier d'arrêt (9) porte une languette d'arrêt (13) élastique ;
- un contour d'arrêt correspondant (21) est prévu dans la zone frontale de l'unité enfichable (1) ; et
- lorsque la poignée de traction à levier (6) est complètement pivotée vers l'extérieur, la languette d'arrêt (13) passe derrière le contour d'arrêt (21) et bloque ainsi la poignée de traction à levier (6) contre tout pivotement.

2. Unité enfichable selon la revendication 1,
**caractérisée en ce que**
- le levier d'arrêt (9) comprend un cliquet (11) qui sert à encliqueter la poignée de traction à levier (6) complètement pivotée vers l'intérieur ; et
- la languette d'arrêt (13) est montée sur le cliquet (11).

3. Unité enfichable selon la revendication 2, **caractérisée en ce que** le cliquet (11) comporte un ergot d'encliquetage (12) qui peut venir s'encliqueter derrière une arête d'encliquetage (16) dans la zone frontale de l'unité enfichable (1).

4. Unité enfichable selon la revendication 3, **caractérisée par** une plaque frontale (4) comportant une découpe (14) qui forme l'arête d'encliquetage (26) et par laquelle pénètre le cliquet (11).

5. Unité enfichable selon l'une des revendications 2 à 4, **caractérisée en ce que** lorsque l'unité enfichable (1) est complètement insérée, le cliquet (11) actionne un commutateur (15) pour la commutation active-passive de l'unité enfichable (1).

6. Unité enfichable selon l'une des revendications 1 à 5, **caractérisée en ce qu'**un élément d'actionnement (17), qui coopère avec l'arête de butée (2) antérieure de la baie de telle façon que lors de l'insertion de l'unité enfichable (1) la poignée de traction à levier (6) se débloque automatiquement, agit sur la languette d'arrêt (13).

7. Unité enfichable selon la revendication 6, **caractérisée en ce que** l'élément d'actionnement (17) est réalisé en prolongement de la languette d'arrêt (13) et repose de manière précontrainte contre le bras de levier (8) de la poignée de traction à levier (6).

8. Unité enfichable selon la revendication 6 ou 7, **caractérisée en ce que** l'élément d'actionnement (17) est supporté de manière à coulisser longitudinalement sur le bras de levier (8).

9. Unité enfichable selon l'une des revendications 1 à 8, **caractérisée en ce que** le levier d'arrêt (9) comprend un bras d'actionnement (10).

10. Unité enfichable selon la revendication 9, **caractérisée en ce que** le bras d'actionnement (10) a une section transversale en forme de U, entre les branches de U de laquelle le bras de poignée (7) de la poignée de traction à levier (6) peut s'insérer par pivotement.

11. Unité enfichable selon l'une des revendications 1 à 10, **caractérisée en ce qu'**une plaque frontale (4) comprend une partie latérale (5a) coudée, essentiellement plane, dont la zone angulaire est réalisée en contour d'arrêt (21).

12. Unité enfichable selon l'une des revendications 1 à 10, **caractérisée en ce qu'**une pièce d'angle (33) sur laquelle la poignée de traction à levier (6) est supportée de manière pivotante et sur laquelle est réalisé le contour d'arrêt (21), est prévue dans la zone angulaire de la plaque frontale (4).
